# EUROPEAN PATENT APPLICATION

(11) **EP 4 224 249 A1**
(43) Date of publication of application: **09.08.2023**
(21) Application number: 22155104.7
(22) Date of filing: 04.02.2022
(51) Int. Cl.: G02F 1/03, H01L 31/00, H04B 3/00

(54) **ELECTROOPTIC OR OPTOELECTRIC INTEGRATED CIRCUIT ENABLING A BIAS-TEE AND METHOD FOR FABRICATING THE SAME**

(71) Applicant: ETH Zurich, 8092 Zurich (CH)
(72) Inventor: MOOR, David, 8805 Richterswil (CH); LEUTHOLD, Juerg, 8173 Neerach (CH)
(74) Representative: Gygi, Andreas

(57) **Abstract**

The invention relates to an integrated circuit (1), comprising: a substrate (10) which supports an electrooptic or optoelectric transducer (11) and a capacitor (12), wherein at least one electrically conductive element of the transducer (11) and at least one electrically conductive element of the capacitor (12) are arranged essentially at the same level with respect to the substrate (10). The invention further relates to a method for fabricating the same.

## Description

### FIELD OF THE INVENTION

The present invention relates to an integrated circuit and to a method for fabricating an integrated circuit. In particular, the present invention relates to an electrooptic or optoelectric integrated circuit enabling capacitive signal coupling and to a method for fabricating an electrooptic or optoelectric integrated circuit enabling capacitive signal coupling. In particular, the present invention relates to an electrooptic or optoelectric integrated circuit enabling a Bias-Tee and to a method for fabricating an electrooptic or optoelectric integrated circuit enabling a Bias-Tee.

### BACKGROUND ART

Electrooptic transducers or optical transmitters enable converting an electrical or radio-frequency (RF) signal into an optical signal, for example, for transmission through an optical fiber. Optoelectric transducers or optical receivers enable converting an optical signal into an electrical signal, for example, an optical signal received from an optical fiber. Optical transceivers enable converting both an electrical signal into an optical signal and converting an optical signal into an electrical signal. Electrooptic and optoelectric transducers enable communication via optical channels at high bandwidth or speed, low power consumption and high conversion efficiency. Applications include transatlantic communications, inter data-center communications, intra data-center communications, fiber-to-home communications, and many more.

For operating electrooptic or optoelectric transducers, electrooptic modulators, RF-detectors, RF-emitters, photodiodes, etc., often a bias voltage and/or current is required, for example, as a power source, for defining a working point, for influencing the distribution of charge carriers in the device, etc. This low-frequency or direct current (DC) bias needs to be combined with a high-frequency signal, which in particular carries communication information. The bias is usually varying slowly, if at all. Combining the two electric paths, low-frequency and high-frequency, is challenging, in particular as regards impairment of the high-frequency path and impairment of the communication information carried in the high-frequency path. For the purpose of combining a low-frequency and a high-frequency path, circuits having the form of a T can be employed, wherein a horizontal and/or a vertical bar of the T can include a capacitor for providing a coupling of a high-frequency (communication) signal and an inductor for providing a decoupling of the high-frequency (communication) signal from a bias source. This kind of circuits is known as Bias-Tee, BT, or Bias T.

Bias-Tees are employed for both, electrooptic and optoelectric transducers. In electrooptic transducers, they often serve: a) to set an operation point by offsetting an average input voltage; b) as a part of fabricating the device to pole or repole an active material prior to operation; c) as a part of operating the device to pole, repole or otherwise enable an active material. In optoelectric transducers, they often serve: a) to allow an external source to set an operation point; b) to tap off a current generated by an average intensity of light and utilize it as a power source.

A Bias-Tee can be implemented on the basis of a discrete RFIC (radio frequency integrated circuit), fully packaged components, a RF PCB (radio frequency printed circuit board), or a driving IC (integrated circuit).

A Bias-Tee can be implemented on the basis of a discrete RFIC (radio frequency integrated circuit), fully packaged components, a RF PCB (radio frequency printed circuit board), or a driving IC (integrated circuits).

US2011062315A1 discloses a photodetector arrangement with a photoreceiver which comprises a photodiode, a blocking capacitor for high frequency and a terminal resistance lying at the signal output of the photodiode. The photodiode is connected to a first bias connection for the supply with a blocking voltage, and a second bias connection is connected to the terminal resistance for the control of the potential at the signal output. A further blocking capacitor is provided for the high-frequency-technological earthing of the terminal resistance. A monolithically integrated optoelectronic componentry in waveguide integration with a layer construction is disclosed.

### DISCLOSURE OF THE INVENTION

There may be a need for an improved integrated circuit and for an improved method for fabricating an integrated circuit. In particular, there may be a need for an improved electrooptic or optoelectrical integrated circuit enabling a Bias-Tee and for an improved method for fabricating an electrooptic or optoelectrical integrated circuit enabling a Bias-Tee.

Such a need may be met with the subject-matter of the independent claims. Advantageous embodiments are defined in the dependent claims.

Ideas underlying embodiments of the present invention may be interpreted as being based, inter alia, on the following observations and recognitions.

An aspect of the invention relates to an integrated circuit comprising a substrate which supports an electrooptic or optoelectric transducer and a capacitor. At least one electrically conductive element of the transducer and at least one electrically conductive element of the capacitor are arranged essentially at the same level with respect to the substrate. The integrated circuit is adapted to ever-increasing data-rates. The integrated circuit is integrated more compactly to meet bandwidth and power requirements. The integrated circuit enables cointegration, in particular when there is no room for extra chips or components in the signal path. Cointegration enables optimizing stray capacitances, parasitic resistances/inductances, etc. The integrated circuit enables very high bias voltages, which are difficult to handle in prior art RFICs. The integrated circuit can be fabricated in a single fabrication process and integrating the bias circuit (Bias-Tee or BT) in the electrooptic or optoelectric part of the system solves problems of the prior art in a cost-efficient, manufacture-tolerant and compact solution. Biasing is enabled for high frequencies and/or large bias voltages, in particular without imposing special needs as regards materials and/or lithography. Typical constraints as regards voltage, bandwidth, and/or size are removed. At the same time a device with faster operation is enabled, a more compact device is provided, less manufacturing steps are required for fabricating the device, a device with a larger bias range is enabled, less design time is required, a cheaper device is enabled, and a more adaptive device is enabled.

In some embodiments, one or more elements or one or more groups of elements of the capacitor have essentially the same form as an element or a group of elements of the transducer. Fabrication of the transducer and capacitor in a single fabrication process is enabled.

In some embodiments, a group of elements of the transducer includes a waveguide arranged between two electrodes. Various types of transducers are enabled.

In some embodiments, a group of elements of the transducer includes a doped silicon element supporting an electrode.

In some embodiments, a group of elements of the transducer includes a nonlinear element arranged between two electrodes.

In some embodiments, a group of elements of the transducer includes a doped region of the substrate arranged between two electrodes.

In some embodiments, the transducer includes a plasmonic waveguide.

In some embodiments, the transducer includes a photonic waveguide.

In some embodiments, the substrate includes an area at a first level for supporting the transducer and an area at a second level different from the first level for supporting the capacitor, and wherein the essentially same level of the at least one electrically conductive element of the transducer respectively of the capacitor is defined with respect to the first level of the substrate respectively with respect to the second level of the substrate. The invention not only applies to a flat top surface of the substrate, but also to a stepped surface of the substrate.

In some embodiments, the at least one electrically conductive element of the transducer includes a first electrode and the at least one electrically conductive element of the capacitor includes a coupled capacitor plate, wherein a part of the coupled capacitor plate coincides with the first electrode. Size and parasitic effects can be further reduced.

In some embodiments, the capacitor includes a coupled capacitor plate for coupling with the transducer and a decoupled capacitor plate for receiving a high-frequency signal.

In some embodiments, the capacitor has the form of a finger capacitor.

In some embodiments, the substrate further supports an inductor having one end for coupling with the transducer and another end for receiving a low-frequency or direct current signal. An integrated circuit comprising a Bias-Tee is enabled.

In some embodiments, the integrated circuit further includes one or more antennas.

In some embodiments, the integrated circuit further includes one or more filter circuits. Filter circuits enable pre-emphasis, equalization, multiplexing etc.

In some embodiments, the integrated circuit further includes one or more microwave mixers.

In some embodiments, the integrated circuit includes a travelling wave modulator.

In some embodiments, the integrated circuit further includes active circuits for adjusting an operating point.

The invention further relates to a method for fabricating an integrated circuit as disclosed, wherein a substrate is provided, and wherein a transducer and a capacitor are arranged on the substrate using a single fabrication process. The single fabrication process can be applied once for fabricating the transducer and the capacitor at the same time. The single fabrication process can be applied multiple times for fabricating the transducer and the capacitor sequentially.

In some embodiments, an inductor is arranged on the substrate using the single fabrication process. Arranging a Bias-Tee is enabled.

In some embodiments, the single fabrication process includes one or more of a deposition process, a patterning process, an etching process, and a doping process.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1A schematically shows a circuit diagram of an electrooptic circuit for converting an electrical input signal into an optical output signal;
Fig. 1B schematically shows a circuit diagram of an optoelectric circuit for converting an optical input signal into an electrical output signal;
Fig. 2 schematically shows a top view of an integrated circuit according to the invention;
Fig. 2A schematically shows a cross-section along line A-A indicated in Fig. 2 of an integrated circuit according to the invention;

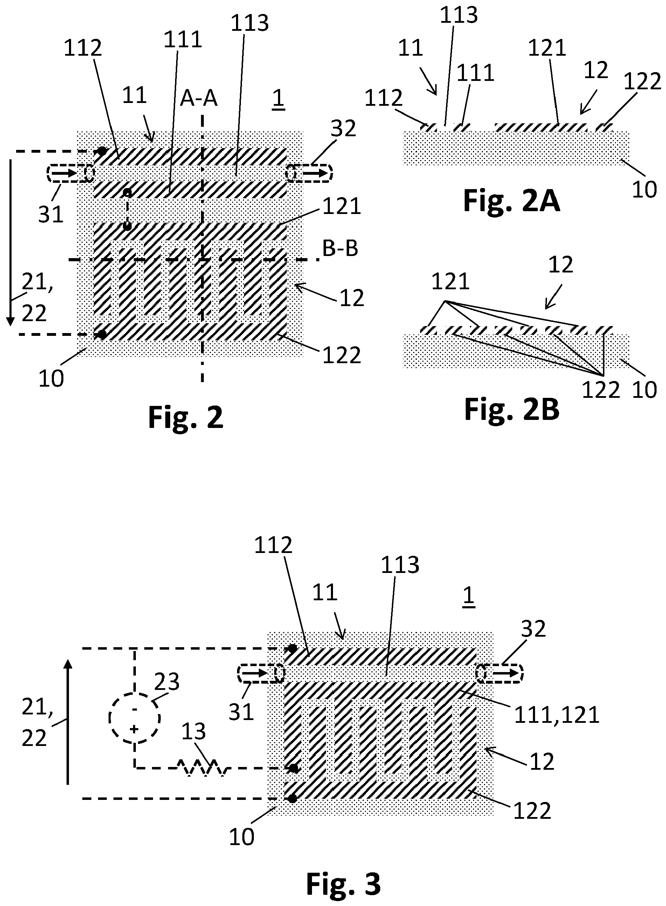

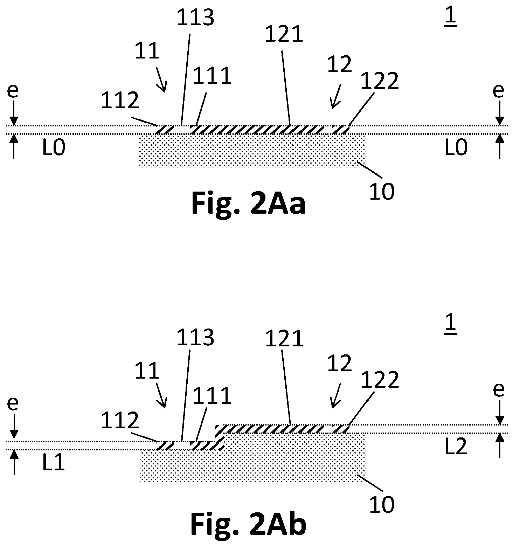

Fig. 2A schematically shows a cross-section along line B-B indicated in Fig. 2 of an integrated circuit according to the invention;
Figs. 2Aa, 2Ab schematically illustrate cross-sections of different embodiments of integrated circuits according to the invention;

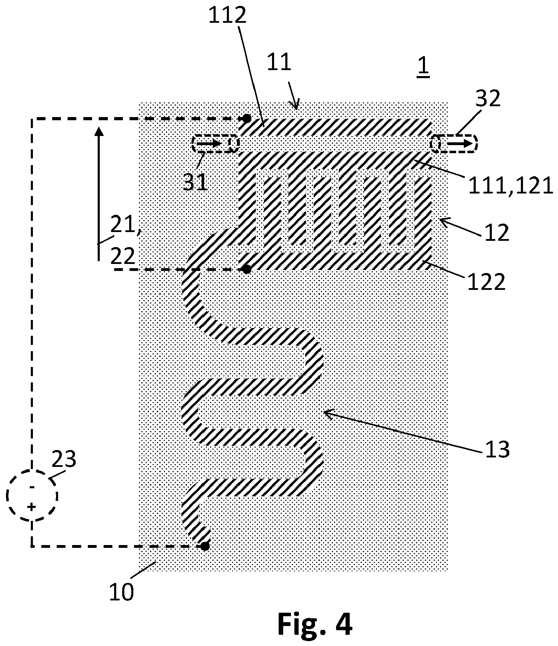

Figs. 3, 4 schematically show top views of integrated circuits according to the invention;

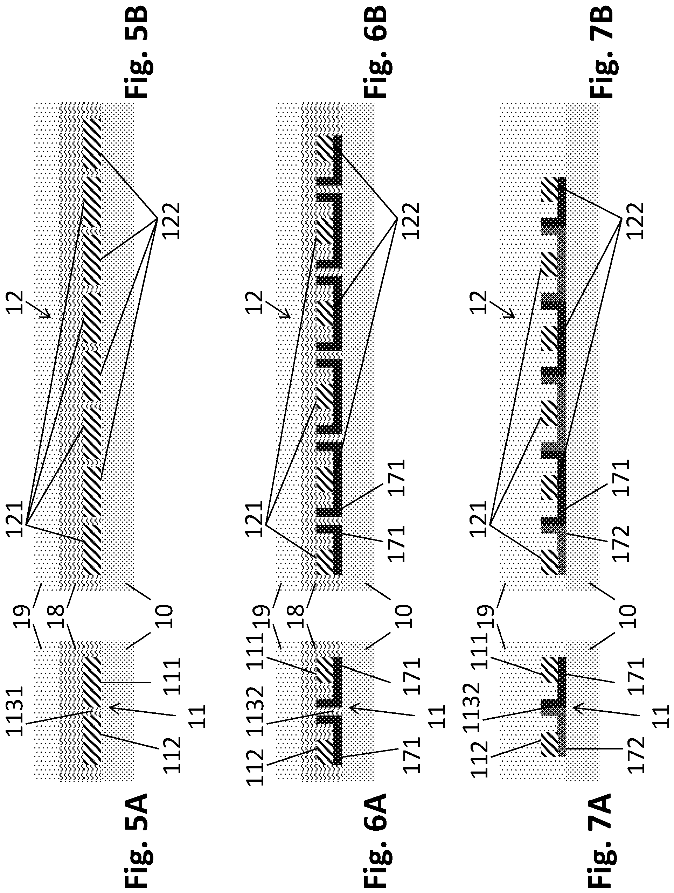

Figs. 5A, 5B, 6A, 6B, 7A, 7B, 8A, 8B, 9A, 9B, 10A, 10B, 11A, 11B, 12A, 12B, 13A, 13B schematically show cross-sections of embodiments of integrated circuits according to the invention;

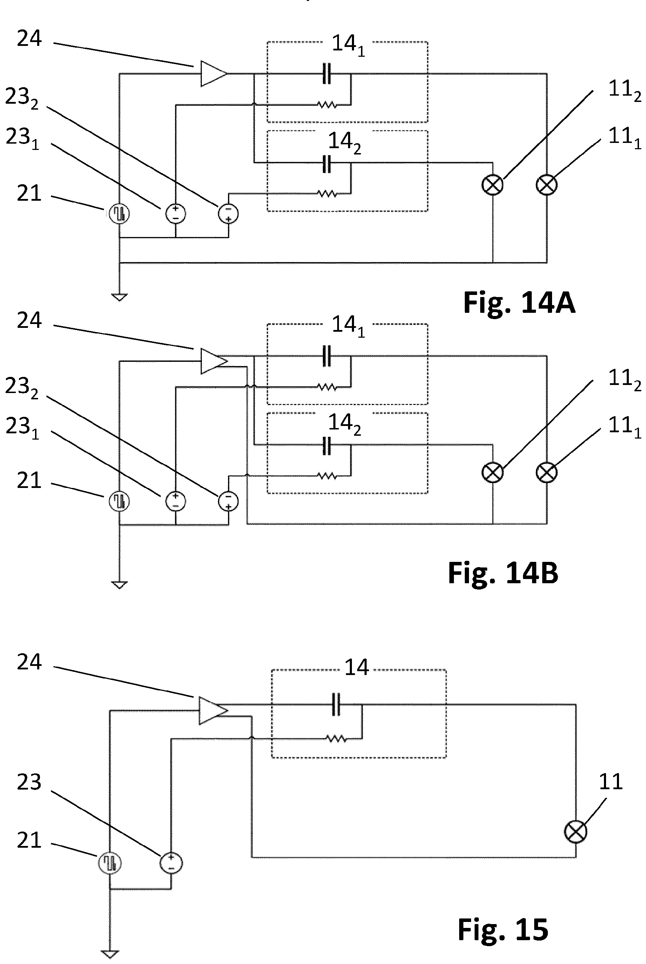

Figs. 14A schematically shows a circuit diagram of a possible Mach-Zehnder application of an integrated circuit according to the invention;
Fig. 14B schematically shows a possible dual-drive Mach-Zehnder application of an integrated circuit according to the invention;
Fig. 15 schematically shows a circuit diagram of a possible Dual-Drive Phase Modulator application of an integrated circuit according to the invention;

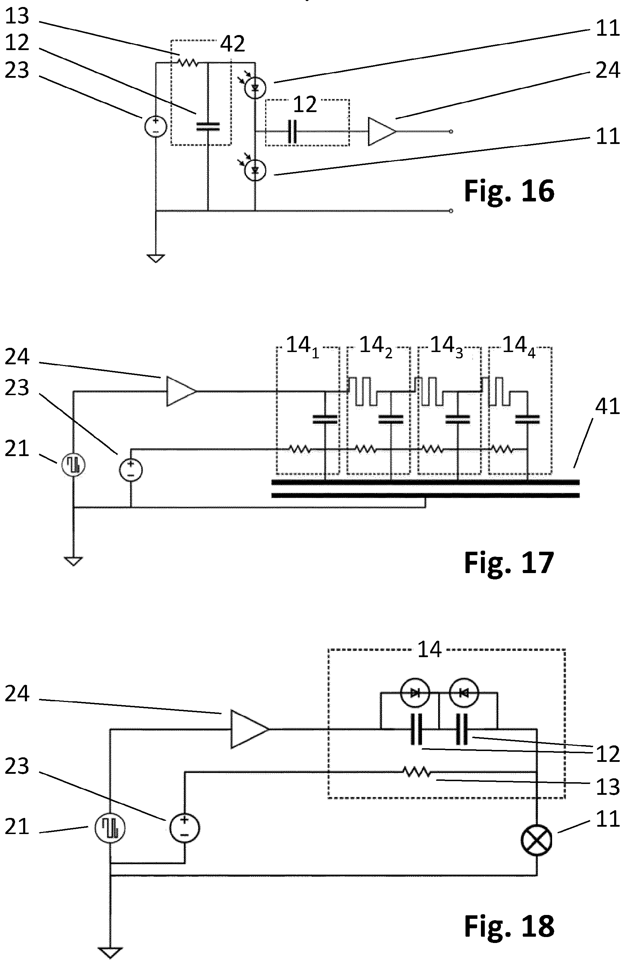

Fig. 16 schematically shows a circuit diagram of a possible Differential Photodiode application of an integrated circuit according to the invention;
Fig. 17 schematically shows a possible form of an integrated circuit according to the invention having the form of a Travelling Wave Modulator;
Fig. 18 schematically shows a circuit diagram of a possible Phase Modulator application of an integrated circuit according to the invention;

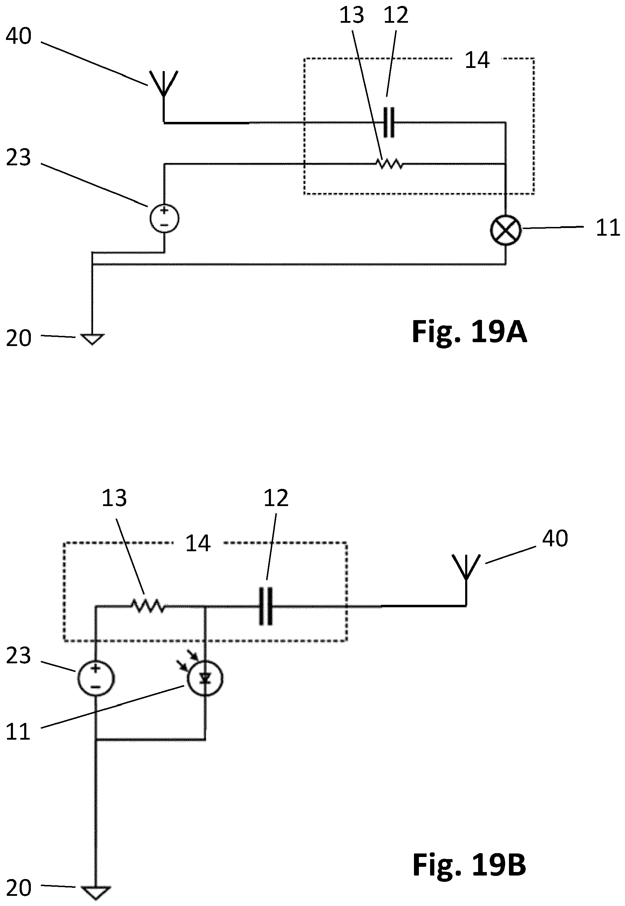

Figs. 19A, 19B schematically show circuit diagrams of possible antenna applications of an integrated circuit according to the invention;

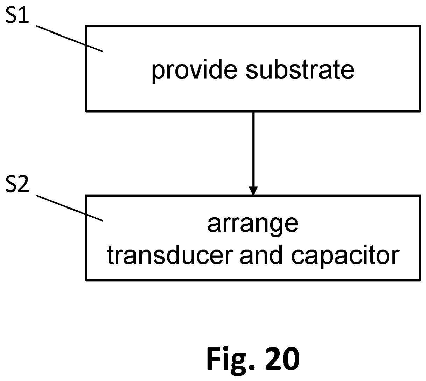

Fig. 20 schematically shows a possible flow diagram of a method for fabricating an integrated circuit according to the invention.

The figures are only schematic and not to scale. Same reference signs refer to same or similar features.

### MODE(S) FOR CARRYING OUT THE INVENTION

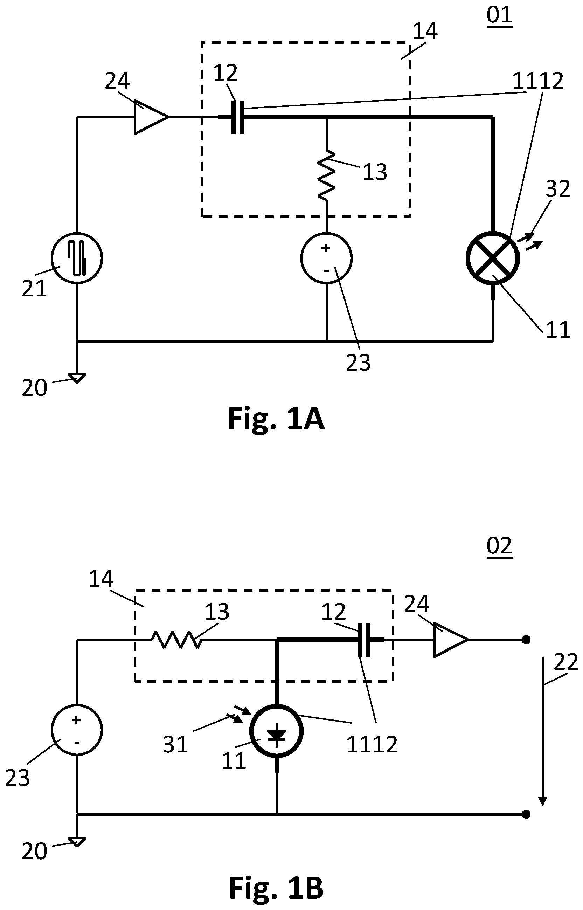

Fig. 1A schematically shows a circuit diagram of an electrooptic circuit 01 for converting an electrical input signal 21 into an optical output signal 32. The electrical signal 21 is shown in the form of an AC (alternate current) signal source having one end connected to reference potential 20 and providing the electrical input signal 21 on another end, which is connected via an optional amplifier 24 to one end of a capacitor 12. Another end of the capacitor 12 is connected via inductor 13 to one end of a bias source 23 and to one end of an electrooptic transducer 11. Another end of the bias source 23 and of the electrooptic transducer 13 are connected to reference potential 20. The bias source 23 can have the form of a DC (direct current) source, for example for defining a working point of the electrooptic transducer 11. The capacitor 12 operates as a coupling capacitor for coupling the electrical signal 21 to the electrooptic transducer 11. The inductor 13 operates as a decoupling inductor for decoupling the bias source 23 from the electrical signal 21. The electrooptic transducer 11 can have the form of a modulator for modulating the optical signal 32 in accordance with the electrical signal 21.

Fig. 1B schematically shows a circuit diagram of an optoelectric circuit 02 for converting an optical input signal 31 into an electrical output signal 22. The optical signal 31 is received by the optoelectric transducer 11. One end of the optoelectric transducer 11 is connected to reference potential 20. Another end of the optoelectric transducer 11 is connected via an inductor 13 to one end of a bias source 23 and to one end of a capacitor 12. Another end of the bias source 23 is connected to reference potential 20. Another end of the capacitor 12 is connected to an input of an optional amplifier 24. An output of the optional amplifier 24 generates the electrical signal 22. The bias source 23 can have the form of a DC (direct current) source, for example for defining a working point of the optoelectric transducer 11. The capacitor 12 operates as a coupling capacitor for coupling the electrical signal 22 generated by the optoelectric transducer 11 to the optional amplifier 24. The inductor 13 operates as a decoupling inductor for decoupling the bias source 23 from the electrical signal 22 generated by the optoelectric transducer 11. The optoelectric transducer 11 can have the form of a photodiode for generating the electrical signal 22 in accordance with the optical signal 31.

The optional amplifiers 24 illustrated in Fig. 1A, 1B can have the form of a transimpedance amplifier.

As illustrated in Fig. 1A, 1B with bold lines and reference numeral 1112 and disclosed in more detail below, an integrated circuit 1 in accordance with the invention includes an electrically conductive element of a transducer 11 and an electrically conductive element of a capacitor 12 which are arranged essentially at the same level with respect to a substrate 10 of the integrated circuit 1.

The capacitor 12 connected to the inductor 13 illustrated in Fig. 1A, 1B provide Bias-Tees 14. The Bias-Tee 14 illustrated in Fig. 1A has the purpose of enabling converting an electrical signal 21 into an optical signal 32. The Bias-Tee 14 illustrated in Fig. 1B has the purpose of enabling converting an optical signal 31 into an electrical signal 22. One end of the capacitor 12 and one end of the inductor 13 are connected to the electrooptic or optoelectric transducer 11.

Fig. 2 schematically shows a top view of an integrated circuit 1 comprising a substrate 10 which supports an electrooptic or optoelectric transducer 11 and a capacitor 12. Fig. 2A schematically shows a cross-section of the integrated circuit 1 along a line A-A shown in Fig. 2. Fig. 2B schematically shows a cross-section of the integrated circuit 1 along a line B-B shown in Fig. 2.

The transducer 11 comprises a waveguide 113 arranged between a first electrode 111 and a second electrode 112. The waveguide 113 enables coupling an optical input signal 31 into the waveguide 113 at one end and coupling an optical output signal 31 from the waveguide 113 at another end.

The capacitor 12 comprises a coupled capacitor plate 121 for coupling with the transducer 11 and a decoupled capacitor plate 122 for receiving a high-frequency signal.

As illustrated in Fig. 2, the integrated circuit 1 enables forming a capacitor 12 serially connected to an electrooptic transducer 11 illustrated in Fig. 1A of an electrooptic circuit 01, or forming an optoelectric transducer 11 serially connected to a capacitor 12 illustrated in Fig. 1B of an electrooptic circuit 02. Respective electrical connections, electrical signals 21, 22 and optical signals 31, 32 for partially providing circuits 01, 02 according to Figs. 1A, 1B are illustrated with dashed lines in Fig. 2.

The capacitor 12 illustrated in Fig. 2 has the form of a finger capacitor. The coupled electrode 121 of the capacitor 12 and the decoupled electrode 122 of the capacitor 12 include plates in the form of meshed fingers which are arranged side by side from each other, thereby providing a capacitive effect. The cross-section B-B illustrated in Fig. 2B further illustrates the plates of the coupled and decoupled electrodes 121, 122 in the form of meshed fingers.

As schematically shown in Fig. 2A, an electrically conductive element of the transducer 11 and an electrically conductive element of the capacitor 12 are arranged essentially at the same level with respect to the substrate 10. In the embodiment of the integrated circuit 1 illustrated in Fig. 2A, the electrodes 111, 112 of the transducer 11 and the electrodes 121, 122 of the capacitor 12 are deposited on the substrate 10, thereby being arranged essentially at the same level with respect to the substrate 10. In particular, as the electrodes 111, 112, 121, 122 are arranged on a top surface of the substrate 10, horizontal planes of the electrodes 111, 112, 121, 122, such as bottom or top surfaces of the electrodes 111, 112, 121, 122, are at essentially the same level above the top surface of the substrate 10. In particular, in a vertical direction with respect to a horizontal plane such as the top or bottom surface of the substrate 10, planes of the electrodes 111, 112, 121, 122, such as bottom or top surfaces of the electrodes 111, 112, 121, 122, are at essentially the same level above the top surface of the substrate 10.

The transducer 11 and the capacitor 12 can be fabricated using a single fabrication process. The single fabrication process can be applied a first time for fabricating the transducer 11, and a second time for fabricating the capacitor 12. Thus, the transducer 11 and the capacitor 12 can have the same fabrication tolerances.

Fig. 2Aa schematically shows a cross-section corresponding to cross-section A-A illustrated in Fig. 2A of an integrated circuit 1 according to the invention. The first electrode 111 of the transducer 11 and the coupled electrode 121 of the capacitor 12 form a single piece. As illustrated in Fig. 2Aa, a top surface of the substrate 10 defines a substrate level L0. As illustrated in Fig. 2Aa, top surfaces of the electrodes 111, 112, 121, 122 are arranged essentially at level e above substrate level L0.

Fig. 2Ab schematically shows a cross-section corresponding to cross-section A-A of an integrated circuit 1 according to the invention. The substrate 10 includes a top surface at a first substrate level L1 and a top surface at a second substrate level L2, which is different from the first substrate level L1. Thus, the top surface of the substrate 10 is not a single plane, but two or more planes which are separated by one or more steps. The electrodes 111, 112, 121, 122 are arranged essentially at the same level above the substrate 10, in particular the electrodes 111, 112 are arranged essentially at the same level e above the first substrate level L1, and the electrodes 121, 122 are arranged essentially at the same level e above the second substrate level L2. For example, because of a difference between the first level L1 and the second level L2, additional conductive material is deposited for connecting the first electrode 111 of the transducer 11 with the coupled electrode 121 of the capacitor 12, which normally does not require additional fabrication steps. For example, the difference between the first level L1 and the second level L2 amounts to between 0.5 - 2 um (micrometer). For example, the introduction of multiple levels may be required to electrically isolate the capacitor 12 from the substrate 10 or in order to form vertical plate capacitors.

Fig. 3 illustrates a top view of an integrated circuit 1 according to the invention. Contrary to the embodiment illustrated in Fig. 2, a first electrode 111 of a transducer 11 and a coupled electrode 121 of a capacitor 12 are formed from a single piece. The transducer 11 and the capacitor 12 are cointegrated using a single fabrication process. As illustrated in Fig. 3, the integrated circuit 1 enables forming a Bias-Tee 14, wherein the capacitor 12 is serially connected to the transducer 11, and wherein an inductor 13 is serially connected to the transducer 11 for forming a Bias-Tee 14 as illustrated in the circuit diagrams of Fig. 1A or Fig. 1B of an electrooptic circuit 01 or of an optoelctric circuit 02. As illustrated in Fig. 3 with dashed lines, the inductor 13 is arranged separated or externally from the integrated circuit 1. Further electrical connections, electrical signals 21, 22 and optical signals 31, 32 for partially providing circuits 01, 02 according to Figs. 1A, 1B are illustrated in Fig. 3 also with dashed lines.

Fig. 4 illustrates a top view of an integrated circuit 1 according to the invention. Contrary to the embodiment illustrated in Fig. 3, the integrated circuit 1 includes an inductor 13. The inductor 13 has a meandering form. Thus, using a single fabrication process, a transducer 11 as well as a capacitor 12 and an inductor 13 for forming a Bias-Tee are cointegrated in the integrated circuit 1. Further electrical connections, electrical signals 21, 22 and optical signals 31, 32 for partially providing circuits 01, 02 according to Figs. 1A, 1B are illustrated in Fig. 4 with dashed lines.

Cointegrating a transducer 11 as well as a capacitor 12 and optionally an inductor 13 has the advantages as described earlier in this disclosure, for example as regards optimizing parasitic effects, manufacturing tolerances, size, etc.

The invention comprises two paths, the high-frequency and the low-frequency path. The high-frequency path comprises a series capacitor 12 that needs to minimize a) series resistance b) parasitic capacity to RF (RF: radio frequency) ground c) series inductance, while the specific value needs to be significantly higher than the transducer capacity. The invention has the advantage that fabrication of this capacitor is enabled in the same physical layer as the transducer, possibly with the same lithographic and/or deposition and/or etching process. In particular, an exact copy of the transducer cross-section in either a finger-capacitor or plate-capacitor topology is provided, enabling a particularly efficient implementation. Adressing b) requires that the capacitor should be made as compact as possible and in close proximity to the transducer, which is enabled by the present invention. Adressing a) and c) requires that the fingers of a finger-capacitor need to be wide enough, which is enabled by the present invention. The low-frequency path potentially comprises a series inductor 13 that needs to be designed appropriately to accommodate the lower cutoff frequency needed for the system. In some embodiments, the low-frequency path may be limited to the transducer itself and the capacitor.

Alternatives include using bond wires as inductor, spiral inductor, etc., a resistor may replace the capacitor/inductor, etc. Furthermore, additional elements can be integrated in a similar manner to match the impedance of the device with a driver circuit, with transmission wire impedance, etc.

Figs. 5A, 5B, 6A, 6B, 7A, 7B, 8A, 8B, 9A, 9B, 10A, 10B, 11A, 11B, 12A, 12B, 13A, 13B schematically show cross-sections of embodiments of integrated circuits 1 according to the invention, which include a transducer 11 and a capacitor 12. Figs. 5A, 6A, 7A, 8A, 9A, 10A, 11A, 12A, 13A illustrate a transducer 11 comprising a first electrode 111 and a second electrode. Figs. 5A, 6A, 7A, 8A, 9A, 10A, 11A, 12A, 13A correspond to cross-section A-A illustrated in Fig. 2A. Figs. 5B, 6B, 7B, 8B, 9B, 10B, 11B, 12B, 13B illustrate a capacitor 12 comprising a coupled electrode 121 and a decoupled electrode 122. Figs. 5B, 6B, 7B, 8B, 9B, 10B, 11B, 12B, 13B correspond to cross-section B-B illustrated in Fig. 2B. Further explanations of the particular examples are provided below. Fabrication of integrated circuits 1 using a single fabrication process is enabled, resulting in integrated circuits 1 which have the elements of the transducer 11 and the elements of the capacitor 12 arranged essentially at the same level with respect to the substrate 10. In particular, electrodes 111, 112 of the transducer 11 and electrodes 121, 122 of the capacitor 12 are arranged essentially at the same level with respect to the substrate 10. In some embodiments, in particular unless specified otherwise, elements of the transducer 11 and the capacitor 12 have a rectangular or quadratic cross-section. In particular, the elements of the transducer 11 and the elements of the capacitor 12 are fabricated with exactly the same materials and dimensions, wherein any combination of a waveguide and a capacitor is possible. Furthermore, optical feedback as in a microring, racetrack modulator, etc. is possible.

Figs. 5A, 5B illustrate schematically an integrated circuit 1 comprising electrodes 111, 112, 121, 122 which are deposited on a surface of a substrate 10. An optical material 18 is arranged between the electrodes 111,112. The optical material 18 optionally may cover the electrodes 111, 112, 121, 122 and the substrate 10. The electrodes 111, 112 of the transducer 11 and the optical material 18 between the electrodes 111, 112 of the transducer 11 form a plasmonic waveguide 1131. Optionally, there may be a thin isolating layer between one or both electrodes 111, 112 and the slot 1131. The optical material 18 is covered by an optional cladding 19. The capacitor 12 has the form of a finger capacitor. For example, Fig. 5A relates to the cross-section of a plasmonic TE-mode MIM-style transducer which has a horizontal plasmonic slot-waveguide 1131, e.g. JRD1, LiNbO3, BTO, Graphene, PZT,...=modulator or Ge, InGaAs, Quantum Colloids, Graphene,...=photodiode. For example, Fig. 5B relates to a finger-type MIM implementation of a coupling capacitor 12, which has interleaved electrodes 121, 122, an optional nonlinear material 18, and an optional passive cladding 19.

Figs. 6A, 6B illustrate schematically an integrated circuit comprising L-shaped n-doped silicon elements 171 which are deposited on a surface of a substrate 10, and electrodes 111, 112, 121, 122 which are deposited on the L-shaped n-doped silicon elements 171. The L-shaped n-doped silicon elements 171 are spaced apart from each other, and the longer section of the L-shaped n-doped silicon elements 171 faces the surface of the substrate 10. An optical material 18 covers the electrodes 111, 112, 121, 122, the L-shaped n-doped silicon elements 171 and the substrate 10, and fills the space between the L-shaped n-doped silicon elements 171. The L-shaped n-doped silicon elements 171 and the optical material 18 between the L-shaped n-doped silicon elements 171 form a photonic waveguide 1132. The nonlinear optical material 18 is covered by an optional cladding 19. The capacitor 12 has the form of a finger capacitor. For example, Fig. 6A relates to the cross-section of a photonic-organic slot modulator (silicon-organic hybrid) with a slot waveguide 1132, conducting or high-k spacers 171 which confine the electric field to the slot region.

Figs. 7A, 7B illustrate schematically an integrated circuit 1 comprising L-shaped n-doped silicon elements 171, L-shaped p-doped silicon elements 172 and electrodes 111, 112, 121, 122 which are deposited on the L-shaped silicon elements 171, 172. The L-shaped silicon elements 171, 172 abut each other, and the longer section of the L-shaped silicon elements 171, 172 faces the surface of the substrate 10. An optional cladding 19 covers the electrodes 111, 112, 121, 122, the L-shaped silicon elements 171, 172 and the substrate 10. The L-shaped silicon elements 171, 172 form a photonic waveguide 1132. The capacitor 12 has the form of a finger capacitor. For example, Fig. 7A relates to the cross-section of a semiconductor transducer, e.g. plasma-dispersion effect pn-silicon modulator or pn-photodiode, which has a rib waveguide 1132.

For example, Figs. 6B, 7B relate to a finger-type implementations of coupling capacitors 12, which are matching the transducer cross-section, utilizing fabrication tolerances of respective layers. Interleaved electrodes 121, 122 are connected to conducting or high-k spacers, which confine the electric field to the slot region, an optional nonlinear material 18, and an optional passive cladding 19.

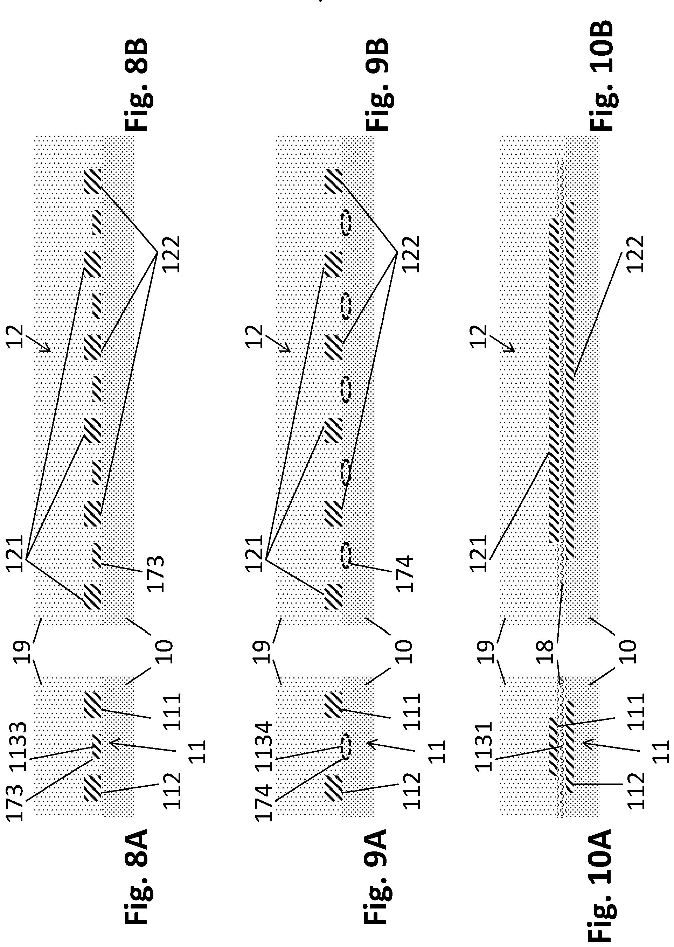

Figs 8A, 8B illustrate schematically an integrated circuit 1 comprising nonlinear elements 173 and electrodes 111, 112, 121, 122 which are deposited on a surface of a substrate 10. The nonlinear elements 173 are arranged between electrodes 111, 112 of the transducer 11 respectively between the electrodes 121, 122 of the capacitor 12. An optional cladding 19 covers the electrodes 111, 112, 121, 122, the nonlinear elements 173 and the substrate 10. At the transducer 11, the nonlinear element 173 forms a nonlinear waveguide 1133. The capacitor 12 has the form of a finger capacitor. For example, Fig. 8A relates to the cross-section of a photonic transducer which has a photonic waveguide 1133 made from a nonlinear electrooptic material, etc. BTO (BaTiO3), LNB (LiNb3), etc. For example, Fig. 8B relates to a finger-type implementation of a coupling capacitor 12, which is matching the transducer 11 cross-section, utilizing fabrication tolerances of respective layers. The design has interleaved electrodes 121, 122, capacitively coupled ridges of the same material as in the transducer 11, and an optional cladding 19.

Figs 9A, 9B illustrate schematically an integrated circuit 1 comprising a doped region 174 at a surface region of the substrate 10 and electrodes 111, 112, 121, 122 which are deposited on a surface of a substrate 10. The doped regions 174 are arranged between electrodes 111, 112 of the transducer 11 respectively between the electrodes 121, 122 of the capacitor 12. An optional cladding 19 covers the electrodes 111, 112, 121, 122, the doped region 174 and the substrate 10. At the transducer 11, the doped region 174 forms a doped waveguide 1134. The capacitor 12 has the form of a finger capacitor. For example, Fig. 9A relates to a cross-section of a photonic transducer which has a photonic waveguide 1134 defined by implantation or doping of a nonlinear electrooptic substrate 101, e.g. LNB, etc. For example, Fig. 9B relates to a finger-type implementation of a coupling capacitor 12, which is matching the transducer 11 cross-section, utilizing fabrication tolerances of respective layers. The design has interleaved electrodes, and an optional cladding 19. Optionally, the implanted or doped area can be replicated to improve control over the capacitance value of the capacitor 12.

Figs. 10A, 10B illustrate schematically an integrated circuit 1 according to the present invention. In recesses at a surface of the substrate 10, a second electrode 112 of a transducer 11 and a decoupled electrode 122 of a capacitor 12 are arranged. The second electrode 112, the decoupled electrode 122 and at least partially the substrate 10 are covered by an optical material 18. A coupled electrode 111 and a coupled electrode 121 are arranged on the optical material 18 above the second electrode 112 respectively the decoupled electrode 122. In some embodiments, an area of the first electrode 111 is smaller than an area of the second electrode 112, and an area of the coupled electrode 121 is smaller than an area of the decoupled electrode 122. The first electrode 111, the coupled electrode 121, the optical material 18, and, if applicable, the substrate 10 are covered with an optional cladding 9. At the transducer 11, the optical material 18 is arranged between the first electrode 111 and the second electrode 112 for forming a plasmonic waveguide 1131. The capacitor 12 has the form of a parallel plate capacitor. For example, Fig. 10A relates to the cross-section of a plasmonic TM-mode MIM-style transducer which has a vertical plasmonic slot-waveguide 1131 with an optical material 18, e.g. spincoated organic electrooptic material like JRD1=modulator or Ge=photodiode. For example, Fig. 10B relates to a plate-type implementation of a coupling capacitor 12, which is matching fabrication tolerances of respective layers. The design has a top electrode 121 and a bottom electrode 122, a spacer layer 18, and an optional passive cladding 19.

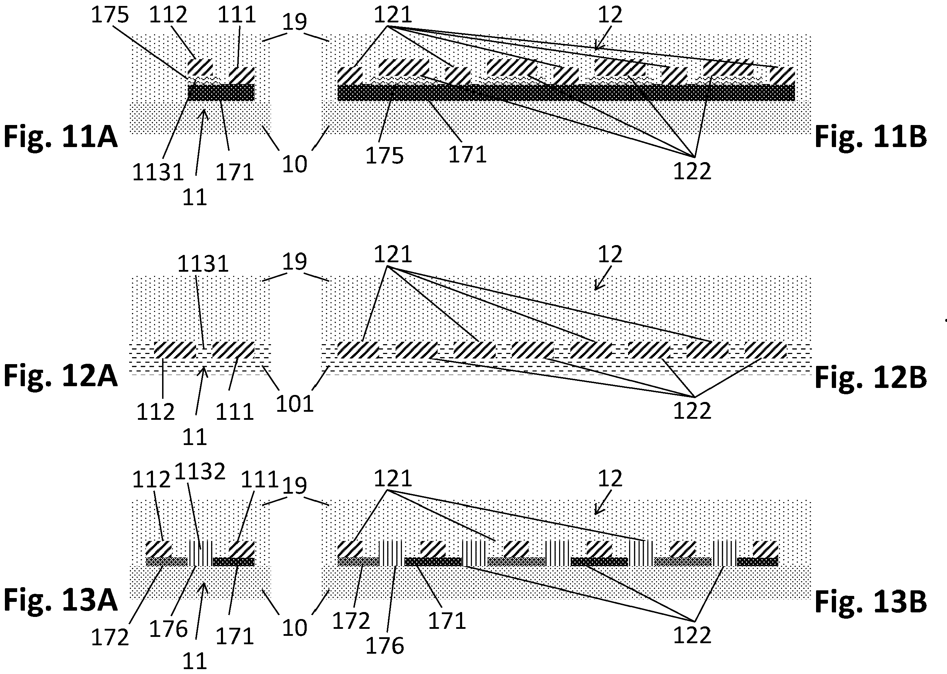

Figs. 11A, 11B illustrate schematically an integrated circuit 1 according to the present invention. An n-doped silicon element 171 is arranged on a surface of a substrate 10. A first electrode 111 and a coupled electrode 121 are arranged on a surface of n-doped silicon elements. A nonlinear dielectric spacer 175 is arranged apart from the first electrode 111 on the n-doped silicon element 171. A second electrode 112 and a decoupled electrode 122 are arranged on a surface of the nonlinear dielectric spacer 175. At the transducer 11, in a region of the nonlinear dielectric spacer 175, a plasmonic waveguide 1131 is enabled. The capacitor 12 has the form of a finger capacitor. For example, Fig. 11A relates to a cross-section of a plasmonic TM-mode MIS-style transducer which has a vertical plasmonic-hybrid slot-waveguide 1131, defined by one metal slab 112, which simultaneously forms one electrode, a nonlinear material 175, e.g. BTO, JRD1=modulator or Ge=photodiode, on a transparent but conductive material 171, e.g. silicon contacted with the first metal electrode 111. For example, Fig. 11B relates to a finger-type implementation of a coupling capacitor 12, which is matching the transducer 11 cross-section, utilizing fabrication tolerances of respective layers. The design has interleaved metal electrodes 121, 122 defining multiple vertical MOS capacitors with spacer 175 on a conductive material 25, e.g. silicon, and an optional passive cladding 19.

Figs. 12A, 12B illustrate schematically an integrated circuit 1 according to the present invention. A nonlinear substrate 101 is provided. In recesses, which are spaced apart from each other, of the nonlinear substrate 101, a first electrode 111, a second electrode 112, a coupled electrode 121, and a decoupled electrode 122 are arranged. At the transducer 11, the first electrode 111, the second electrode 112, and the nonlinear substrate 101 between the first and second electrode 111, 112 form a plasmonic waveguide 1131. The capacitor 12 has the form of a finger capacitor. For example, Fig. 12A relates to a cross-section of a plasmonic TE-mode MIM-style transducer with a horizontal plasmonic slot-waveguide 1131, built buried into a nonlinear substrate 101, e.g. BTO or JRD1=modulator, Ge=photodiode. For example, Fig. 12B relates to a finger-type implementation of a coupling capacitor 12, which is matching the transducer 11 cross-section, utilizing fabrication tolerances of respective layers. The design has interleaved electrodes 121, 122 buried into a nonlinear substrate 101, and an optional passive cladding 19.

Figs. 13A, 13B illustrate schematically an integrated circuit 1 according to the present invention. A n-doped silicon element 171 and a p-doped silicon element 172 are arranged on a surface of a substrate 10. An intrinsic semiconductor 176 is arranged between the silicon elements 171, 172 on the surface of the substrate 10. The intrinsic semiconductor 176 abuts the silicon elements 171, 172. At the transducer 11, a first electrode 111 is arranged on the n-doped silicon element 171, and a second electrode 112 is arranged on the p-doped silicon element 172. At the capacitor 12, a coupled electrode 121 is arranged on the n-doped silicon element 171, and a second electrode 112 is arranged on the p-doped silicon element 172. A cladding 19 covers the electrodes 111, 112, 121, 122, the silicon elements 171, 172, the intrinsic semiconductor 176, and the substrate 10. The intrinsic semiconductor forms a photonic waveguide 1132. The capacitor 12 has the form of a finger capacitor. For example, Fig. 13A relates to a cross-section of a semiconductor pin-diode, which has a rib waveguide 1132, metal electrodes 111, 112, and an intrinsic type semiconductor 176. For example, Fig. 13B relates to a finger-type implementation of a coupling capacitor 12, which is matching the transducer 11 cross-section, utilizing fabrication tolerances of respective layers. The design has interleaved electrodes 121, 122, an intrinsic type semiconductor 176, p- and n-type semiconductors 171, 172, built on a substrate 10, and a passive cladding 19.

Figs. 5A, 5B, 6A, 6B, 7A, 7B, 8A, 8B, 9A, 9B, 10A, 10B, 11A, 11B, 12A, 12B, 13A, 13B schematically show exemplary embodiments of integrated circuits 1 according to the present invention, enabling fabrication in a single fabrication process (e.g. which can be applied a first time for fabricating the transducer 11 and a second time for fabricating the capacitor 12 and/or the inductor 13, etc.). As the person skilled in the art clearly understands, the present invention also relates to various modifications, alterations, etc. of these exemplary embodiments of integrated circuits 1. For example, n-doped silicon elements 171 can be replaced by or exchanged with p-doped silicon elements 172, doped regions 174 can relate to p-doped regions or n-doped regions, etc. More elaborate doping profiles may be beneficial. The use of completely different transducer designs, not described in Figs. 5A, 5B, 6A, 6B, 7A, 7B, 8A, 8B, 9A, 9B, 10A, 10B, 11A, 11B, 12A, 12B, 13A, 13B may be applied.

In some embodiments, the exemplary embodiments illustrated in Figs. 5A, 5B, 6A, 6B, 7A, 7B, 8A, 8B, 9A, 9B, 10A, 10B, 11A, 11B, 12A, 12B, 13A, 13B also include an inductor 13, for example as illustrated in Fig. 4, thereby providing integrated circuits 1 with included Bias-Tee. In other embodiments, a Bias-Tee is enabled by providing an inductor 13 which is external from the integrated circuit 1, for example as illustrated in Fig. 3.

As the skilled person clearly understands, elements of the integrated circuit 1 are formed from various appropriate materials.

For example, electrodes 111, 112, 121, 122 are formed from a metal such as gold (Au), aluminum (Al), copper (Cu), Silver (Ag), Tungsten (W), semi-metal, (intrinsic or highly doped and/or alloyed) semiconductor (doped silicon, silicide, etc.), 2D Van-der Waals layers (e.g. Graphene), ceramics (e.g. TiN), etc.

For example, a substrate 10 can be formed from silicon (Si), silica, quartz, sapphire/Alumina, MgO, diamond, SiC, a processed microelectronic wafer, flexible substrates, etc. For example, a substrate 10 may include any combination of different appropriate materials. A substrate 10 may be planarized by a polishing process or it may exhibit topologies due to prior processing.

For example, electrooptic transducers 11 rely on one or more (nonlinear) optical materials 18 that change their optical properties depending on an applied electric field or current, for example lithium niobate (LNB or LiNb03), barium titanate (BTO or BaTi03), Graphene, PZT, germanium (Ge), silicon (Si), organic materials like JRD1, engineered 2nd and 3rd susceptibility materials and material compositions, etc.

For example, optoelectric transducers rely on one or more (nonlinear) optical materials 18 that change their electrical properties upon incidence of an optical field or light, for example germanium (Ge), silicon (Si), InGaAs, quantum colloids, Graphene, etc.

Figs. 14A, 14B, 15, 16, 17, 18, 19A, 19B schematically show circuit diagrams of possible applications of integrated circuits 1 according to the present invention.

Figs. 14A schematically shows a circuit diagram of a possible Mach-Zehnder application of an integrated circuit 1 according to the invention. Fig. 14B schematically shows a circuit diagram of a dual-drive Mach-Zehnder application of an integrated circuit 1 according to the invention. Fig. 14A shows both arms of a Mach-Zehnder modulator with their corresponding Bias-Tees 14₁, 14₂. and transducers 11₁, 11₂, which are provided in the form of integrated circuits 1 as described above. Fig. 14B shows both arms of a dual-drive Mach-Zehnder modulator with their corresponding Bias-Tees 14₁, 14₂. and transducers 11₁, 11₂, which are provided in the form of integrated circuits 1 as described above.

Fig. 15 schematically shows a circuit diagram of a possible Dual-Drive Phase Modulator application of an integrated circuit 1 according to the invention. A Bias-Tee 14 and a transducer 11 are provide in the form of an integrated circuit 1 as described above.

Fig. 16 schematically shows a circuit diagram of a possible Differential Photodiode application of an integrated circuit 1 according to the invention. Photodiodes 11 and a capacitor 12 are provided in the form of an integrated circuit 1 as described above. An optional supply stabilization 42 is provided in the form of an integrated circuit 1 as described above.

Fig. 17 schematically shows a possible form of an integrated circuit 1 according to the invention having the form of a Travelling Wave Modulator. A possible distribution of a Bias-Tee 14₁, 14₂, 14₃, 14₄ along a travelling wave modulator 41 are provided in the form of an integrated circuit 1 as described above.

Fig. 18 schematically shows a circuit diagram of a possible Phase Modulator application of an integrated circuit according to the invention. Fig. 18 extends the embodiment illustrated in Fig. 1A to adapt for an embodiment of a capacitor 12 as illustrated in Fig. 7B with a parasitic diode parallel to the capacitor 12. Two capacitors are placed in series in opposite direction, thereby providing that no DC current flows backwards towards the AC source. The diode characteristic and the built-in capacitance of the modulator are utilized to implement the bias capacitor.

Figs. 19A, 19B schematically show circuit diagrams of possible antenna applications of an integrated circuit 1 according to the invention. Fig. 19A illustrates an antenna 40, which receives an AC signal, which is connected to a capacitor 12 of an integrated circuit 1 as described above for modulating transducer 11. A DC Bias 23 is coupled via inductor 13 through Bias-Tee 14. Fig. 19B illustrates an on-chip transmitting antenna 40. An optoelectric transducer 11 (photodiode) receives modulated light and transmits a respective AC signal via capacitor 12 of Bias-Tee 14 to antenna 40. A DC bias 23 drives the optoelectric transducer via inductor 13 of Bias-Tee 14.

Fig. 20 schematically shows a possible flow diagram of a method for fabricating an integrated circuit according to the invention. In step S1, a substrate is provided. In some embodiments, the substrate has a flat surface with a level L0. In other embodiments, the substrate has a stepped surface with levels L1, L2. In step S2, a transducer 11 and a capacitor 12 are arranged on the substrate 10 using a single fabrication process. In some embodiments, the single fabrication process is applied once. In other embodiments, the single fabrication process is applied multiple times. In some embodiments, the transducer 11 and the capacitor 12 are arranged on a flat surface of a substrate 10 at level L0. In other embodiments, the transducer 11 is arranged at level L1 of a stepped surface of a substrate 10, and the capacitor 12 is arranged at level L2 of a stepped surface of the substrate 10. Because the transducer 11 and the capacitor 12 are arranged using a single fabrication process, at least one electrically conductive element of the transducer 11 and at least one electrically conductive element of the capacitor 12 are arranged essentially at the same level with respect to the substrate 10, in particular with respect to level L0 in case of a flat surface respectively with respect to levels L1, L2 in case of a stepped surface.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

**LIST OF REFERENCE SIGNS**

| | | | |
|---|---|---|---|
| 1 | integrated circuit | | |
| 01 | circuit diagram electrooptic circuit | 02 | circuit diagram optoelectric circuit |
| 10 | substrate | 101 | nonlinear substrate |
| 11 | electrooptic or optoelectric transducer | 111 | first transducer electrode |
| 112 | second transducer electrode | 113 | waveguide |
| 1131 | plasmonic waveguide | 1132 | photonic waveguide |
| 1133 | nonlinear waveguide | 1134 | doped waveguide |
| 12 | capacitor | 13 | inductor |
| 1112 | electrically conductive element of transducer and capacitor at same level | | |
| 14 | Bias-Tee | 171 | n-doped silicon element |
| 172 | p-doped silicon element | 173 | nonlinear element |
| 174 | doped region | 175 | nonlinear dielectric spacer |
| 176 | intrinsic semiconductor | 18 | optical material |
| 19 | cladding | 21 | electrical input signal |
| 22 | electrical output signal | 31 | optical input signal |
| 32 | optical output signal | 20 | reference potential |
| 21 | electrical input signal | 22 | electrical output signal |
| 23 | bias source | 24 | optional amplifier |
| 40 | antenna | 41 | travelling wave modulator |
| 42 | optional supply stabilization | | |

## Claims

1. An integrated circuit (1), comprising:
a substrate (10) which supports an electrooptic or optoelectric transducer (11) and a capacitor (12), wherein at least one electrically conductive element of the transducer (11) and at least one electrically conductive element of the capacitor (12) are arranged essentially at the same level with respect to the substrate (10).

2. The integrated circuit (1) of claim 1, wherein one or more elements or one or more groups of elements of the capacitor (12) have essentially the same form as an element or a group of elements of the transducer (11).

3. The integrated circuit (1) of claim 1 or 2, wherein a group of elements of the transducer (11) includes a waveguide (113) arranged between two electrodes (111, 112).

4. The integrated circuit (1) of one of claims 1 to 3, wherein a group of elements of the transducer (11) includes a doped silicon element (171, 172) supporting an electrode (111, 112).

5. The integrated circuit (1) of one of claims 1 to 4, wherein a group of elements of the transducer (11) includes a nonlinear element (173) arranged between two electrodes (111, 112).

6. The integrated circuit (1) of one of claims 1 to 5, wherein a group of elements of the transducer (11) includes a doped region (174) of the substrate (10) arranged between two electrodes (111, 112).

7. The integrated circuit (1) of one of claims 1 to 6, wherein the transducer (11) includes a plasmonic waveguide (1131).

8. The integrated circuit (1) of one of claims 1 to 7, wherein the transducer (11) includes a photonic waveguide (1132).

9. The integrated circuit (1) of one of claims 1 to 8, wherein the substrate (10) includes an area at a first level (L1) for supporting the transducer (11) and an area at a second level (L2) different from the first level (L1) for supporting the capacitor (12), and wherein the essentially same level of the at least one electrically conductive element of the transducer (11) respectively of the capacitor (12) is defined with respect to the first level (L1) of the substrate (10) respectively with respect to the second level (L2) of the substrate (10).

10. The integrated circuit (1) of one of claims 1 to 9, wherein the at least one electrically conductive element of the transducer (11) includes a first electrode (111) and the at least one electrically conductive element of the capacitor (12) includes a coupled capacitor plate (121), wherein a part of the coupled capacitor plate (121) coincides with the first electrode (111).

11. The integrated circuit (1) of one of claims 1 to 10, wherein the capacitor (11) includes a coupled capacitor plate (121) for coupling with the transducer (11) and a decoupled capacitor plate (122) for receiving a high-frequency signal.

12. The integrated circuit (1) of one of claims 1 to 11, wherein the capacitor (11) has the form of a finger capacitor.

13. The integrated circuit (1) of one of claims 1 to 12, wherein the substrate further supports an inductor (13) having one end for coupling with the transducer (11) and another end for receiving a low-frequency or direct current signal.

14. A method for fabricating an integrated circuit (1) according to one of claims 1 to 13, wherein a substrate (10) is provided, and wherein a transducer (11) and a capacitor (12) are arranged on the substrate (10) using a single fabrication process.

15. The method of claim 14, wherein an inductor (13) is arranged on the substrate using the single fabrication process.
